# EUROPEAN PATENT APPLICATION

(11) **EP 2 341 547 A2**
(43) Date of publication of application: **06.07.2011**
(21) Application number: 10016166.0
(22) Date of filing: 29.12.2010
(51) Int. Cl.: H01L 31/0216, H01L 31/06, H01L 31/18

(54) **Thin film solar cell and manufacturing method thereof**

(30) Priority: 30.12.2009 TW 98145821
(71) Applicant: Auria Solar Co., Ltd., Tainan 74146 (TW)
(72) Inventor: Tsai, Chin-Yao, Tainan 74146 (TW)
(74) Representative: Brandenburger, Karin

(57) **Abstract**

A thin-film solar cell (300) including a substrate (310), a first conductive layer (320), a plurality of photovoltaic layers (332,334), a second conductive layer (340), a first passivation layer (352) and a second passivation layer (354) is provided. The first conductive layer (320) is disposed on the substrate (310). The photovoltaic layers (332,334) are stacked on the first conductive layer and in electrical tandem, wherein each photovoltaic layer is adapted for generating a photocurrent. The second conductive layer (340) is disposed on the photovoltaic layers. The first passivation layer (352) is disposed on the second conductive layer, and the second passivation layer (354) is disposed on the first passivation layer. The first and second passivation layers (352,354) are used for reflecting the light within a wavelength range into the photovoltaic layers, so as to make the photocurrent generated by the photovoltaic layers being matched. A manufacturing method of the thin-film solar cell is also provided,

## Description

### BACKGROUND OF THE INVENTION

### Field of the Invention

The present invention relates to a solar cell and a manufacturing method thereof, and more particularly, to a thin-film solar cell with improved photoelectric conversion efficiency and a manufacturing method thereof.

### Descriptions of the Related Art

With rising of the environmental protection awareness, the concept of "energy saving and carbon dioxide emission reduction." is gradually receiving more and more attention. Accordingly, exploitation and use of renewable energy sources have become a focus of development all over the world. Among the renewable energy sources, solar cells that are capable of converting the solar energy into the electric energy are considered to be the most promising, so numerous manufacturers are now devoted to production of solar cells. Currently, a critical problem related to solar cells is how to improve the photoelectric conversion efficiency thereof, and any improvement in the photoelectric conversion efficiency of solar cells will lead to improvement in competitive edge of the solar cell products.

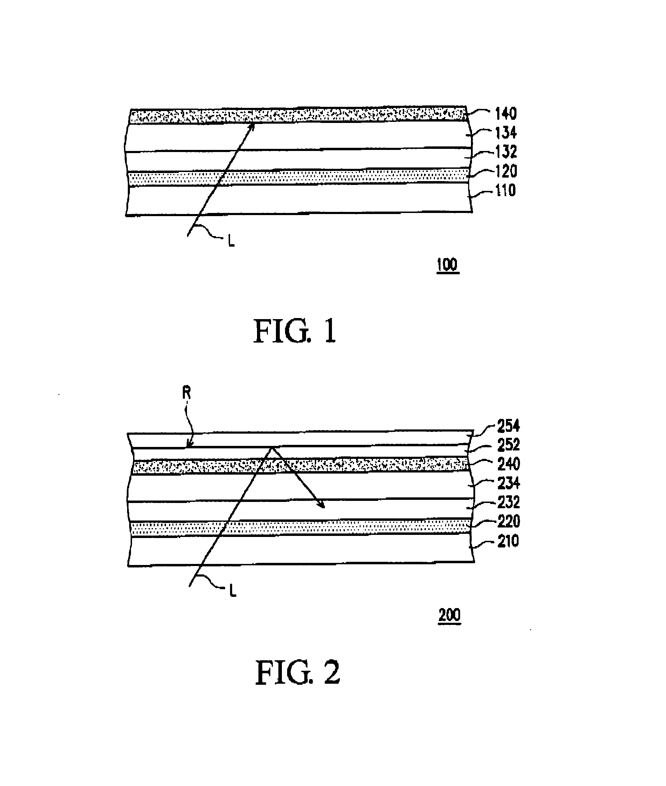

**FIG 1** is a schematic view of a conventional thin-film solar cell. Referring to **FIG 1****,** the thin-film solar cell **100** comprises a substrate **110,** a first conductive layer **120,** a first photovoltaic layer **132,** a second photovoltaic layer **134** and a second conductive layer **140.** The first photovoltaic layer **132** is a photoelectric conversion structure of a p-i-n (PIN) junction design formed by an amorphous silicon thin film, and the second photovoltaic layer **134** is a photoelectric conversion structure of a PIN junction design formed by a microcrystalline silicon thin film. The second photovoltaic layer **134** is stacked on the first photovoltaic layer **132** and in electrical tandem with the first photovoltaic layer **132** to form a tandem junction structure. Because the first photovoltaic layer **132** formed of the amorphous silicon thin film and the second photovoltaic layer **134** formed of the microcrystalline silicon thin film can absorb light rays **L** within different wavelength ranges respectively to generate a photocurrent, the thin-film solar cell **100** can deliver a higher photoelectric conversion efficiency than a thin-film solar cell (not shown) having only a single photovoltaic layer.

Generally speaking, when a light ray L from the outside is irradiated onto the thin-film solar cell 100, electron-hole pairs will be generated by the first photovoltaic layer **132** and the second photovoltaic layer **134** in response to the light ray. Under action of a built-in electric field formed by the PIN junction, the electrons and the holes migrate towards the first conductive layer **120** and the second conductive layer **140** respectively to form a photocurrent. This results in an electric energy storage status. Then if a load circuit or an electronic device is externally connected across the solar cell, the electric energy can be supplied to drive the load circuit or the electronic device.

However, because magnitudes of the photocurrents generated by the first photovoltaic layer **132** and the second photovoltaic layer **134** may vary from each other and the first photovoltaic layer **132** and the second photovoltaic layer **134** are in electrical tandem, the photoelectric conversion efficiency of the thin-film solar cell **100** is limited by one of the first photovoltaic layer **132** and the second photovoltaic layer **134** that has a smaller photocurrent; i.e., a there exists a current unmatching phenomenon. Consequently, this imposes a limitation on the photoelectric conversion efficiency of the thin-film solar cell 100.

### SUMMARY OF THE INVENION

In view of this, the present invention provides a thin-film solar cell, which has improved photoelectric conversion efficiency by making photocurrents generated by a plurality of stacked photovoltaic layers matched with each other.

The present invention also provides a method for manufacturing a thin-film solar cell, with which the aforesaid solar cell can be manufactured.

The thin-film solar cell of the present invention comprises a substrate, a first conductive layer, a plurality of photovoltaic layers, a second conductive layer, a first passivation layer and a second passivation layer. The first conductive layer is disposed on the substrate. The plurality of photovoltaic layers is stacked on the first conductive layer and in electrical tandem with each other, wherein each of the photovoltaic layers is adapted to generate a photocurrent. The second conductive layer is disposed on the photovoltaic Layers. The first passivation layer is disposed on the second conductive layer. The second passivation layer is disposed on the first passivation layer. The first passivation layer and the second passivation layer are used to reflect a light ray within a wavelength range into the photovoltaic layers so as to make the photocurrents generated by the photovoltaic layers matched with each other.

In an embodiment of the present invention, the wavelength range substantially ranges from the ultraviolet (UV) band to the infrared (IR) band.

In an embodiment of the present invention, the wavelength range substantially ranges from 300 nm to 1100 nm.

In an embodiment of the present invention, the first passivation layer has a refractive index different from that of the second passivation layer.

In an embodiment of the present invention, the first passivation layer is made of a light transmissive material and the second passivation layer is made of a reflective material, and the second passivation layer is used to reflect the light ray within the wavelength range into the photovoltaic layers.

In an embodiment of the present invention, the first passivation layer has a thickness identical to that of the second passivation layer.

In an embodiment of the present invention, the first passivation layer has a thickness different from that of the second passivation layer.

In an embodiment of the present invention, the first passivation layer and the second passivation layer are made of a dielectric material, an insulation material, a compound comprising one of the oxygen and nitrogen element, or a combination thereof.

In an embodiment of the present invention, the first passivation layer and the second passivation layer are made of silicon oxide, silicon nitride, silicon oxynitride, or a combination thereof.

In an embodiment of the present invention, the photovoltaic layers include a stack structure of a tandem junction design, a triple junction design or having more than three junctions.

In an embodiment of the present invention, the photovoltaic layer is made of a group IV element semiconductor thin film, a group III-V compound semiconductor thin film, a group II-VI compound semiconductor thin film, an organic compound semiconductor thin film, or a combination thereof.

In an embodiment of the present invention, the group IV element semiconductor thin film comprises at least one of a carbon element thin film, a silicon element thin film, a germanium elemental thin film, a silicon carbide thin film and a germanium silicide thin film, or a combination thereof in a monocrystalline phase, a polycrystalline phase, an amorphous phase or a microcrystalline phase.

In an embodiment of the present invention, the group III-V compound semiconductor thin film comprises at least one of a gallium arsenide (GaAs) compound thin film and an indium gallium phosphide (InGaP) compound thin film or a combination thereof.

In an embodiment of the present invention, the group II-VI compound semiconductor thin film comprises at least one of a copper indium selenium (CIS) compound thin film, a copper indium gallium selenium (CIGS) compound thin film and a cadmium telluride (CdTe) compound thin film, or a combination thereof,

In an embodiment of the present invention, the organic compound semiconductor thin film comprises a mixture of a conjugated polymer donor and a carbon nanosphere acceptor,

In an embodiment of the present invention, the first conductive layer and the second conductive layer are made of a transparent conductive layer.

The method for manufacturing a thin-film solar cell comprises: providing a substrate; forming a first conductive layer on the substrate; stacking a plurality of photovoltaic layers on the first conductive layer, wherein the photovoltaic layers are in electrical tandem with each other and each of the photovoltaic layers is adapted to generate a photocurrent; forming a second conductive layer on the photovoltaic layers; forming a first passivation layer on the second conductive layer; and forming a second passivation layer on the first passivation layer, wherein the first passivation layer and the second passivation layer are each adapted to reflect a light ray within a wavelength range into the photovoltaic layers so as to make the photocurrents generated by the photovoltaic layers matched with each other.

In an embodiment of the present invention, the method for manufacturing a thin-film solar cell further comprises measuring magnitudes of the photocurrents supplied by the photovoltaic layers before forming the first passivation layer or the second passivation layer.

In an embodiment of the present invention, forming the first passivation layer and the second passivation layer comprises performing a screen printing process, a dry film lamination process or a coating process. Additionally, forming the first passivation layer and the second passivation layer further comprises performing a curing process.

The present invention further provides a thin-film solar cell, which comprises a substrate, a plurality of sub-cells, a first passivation layer and a second passivation layer. The plurality of sub-cells is disposed on the substrate, and each of the sub-cells comprises a first conductive layer, a plurality of photovoltaic layers and a second conductive layer. The first conductive layer is disposed on the substrate. The plurality of photovoltaic layers is stacked on the first conductive layer and in electrical tandem with each other, Each of the photovoltaic layers is adapted to generate a photocurrent, and the photovoltaic layers have an opening exposing the first conductive layer. The second conductive layer is disposed on the photovoltaic layers and electrically connected with the first conductive layer of an adjacent one of the sub-cells through the opening. The first passivation layer is disposed on the second conductive layer of each of the sub-cells. The second passivation layer is disposed on the first passivation layer. The first passivation layer and the second passivation layer are used to reflect a light ray within a wavelength range into the photovoltaic layers so as to make the photocurrents generated by the photovoltaic layers matched with each other.

According to the above descriptions, because the thin-film solar cell of the present invention has a first passivation layer and a second passivation layer disposed on the second conductive layer to reflect light rays within a wavelength range, photocurrents generated by the plurality of photovoltaic layers can be made to be matched with each other. Thus, the photoelectric conversion efficiency of the thin-film solar cell gets improved. Furthermore, a method for manufacturing a thin-film solar cell is also disclosed in the present invention, with which the aforesaid thin-film solar cell can be manufactured.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG 1** is a schematic view of a conventional thin-film solar cell;
**FIG 2** is a schematic view of a thin-film solar cell according to an embodiment of the present invention;
**FIGS. 3A** to **3F** illustrate a process of manufacturing a thin-film solar cell according to an embodiment of the present invention; and
**FIG 4** is a schematic view of a thin-film solar cell according to another embodiment of the present invention.

### DESCRIPTION OF THE PREFERRED EMBODIMENT

**FIG. 2** is a schematic view of a thin-film solar cell according to an embodiment of the present invention. Referring to **FIG. 2****,** the thin-film solar cell **200** comprises a substrate **210,** a first conductive layer **220,** a first photovoltaic layer **232,** a second photovoltaic layer **234,** a second conductive layer **240,** a first passivation layer **252** and a second passivation layer **254.**

The first conductive layer **220** is disposed on the substrate **210.** In this embodiment, the first conductive layer **220** is a transparent conductive layer, which may be made of at least one of zinc oxide, tin oxide, indium tin oxide (ITO), indium zinc oxide (IZO), indium tin zinc oxide (ITZO), aluminum tin oxide (ATO), aluminum zinc oxide (AZO), cadmium indium oxide (CIO), cadmium zinc oxide (CZO), gallium zinc oxide (GZO) and tin oxyfluoride.

The first photovoltaic layer **232** and the second photovoltaic layer **234** are in electrical tandem with each other and stacked on the first conductive layer **220.** The first photovoltaic layer **232** and the second photovoltaic layer **234** are each adapted to generate a photocurrent. In this embodiment, for example, the first photovoltaic layer **232** is an amorphous silicon thin film, and the second photovoltaic layer **234** is a microcrystalline silicon thin film. In other embodiments, there may also be three or more photovoltaic layers that form a stack structure; and what described above is only for illustration purpose and the present invention has no limitation on the number of the photovoltaic layers in the thin-film solar cell.

In detail, the first photovoltaic layer **232** and the second photovoltaic layer **234** may be photoelectric conversion structures of a p-i-n (PIN) junction design, which is comprised of a P-type semiconductor layer, an intrinsic layer and an N-type semiconductor layer. In some embodiments, the first photovoltaic layer **232** and the second photovoltaic layer **234** may also be photoelectric conversion structures of a p-n (PN) junction design without having an intrinsic layer. Alternatively, one of the first photovoltaic layer **232** and the second photovoltaic layer **234** may be a photoelectric conversion structure of a PIN junction design, while the other may be a photoelectric conversion structure of a PN junction design, This may vary depending on requirements and design of the users; and what described above is only for illustration purpose and the present invention is not merely limited thereto.

In this embodiment, the first photovoltaic layer **232** and the second photovoltaic layer **234** may be semiconductor thin films formed of a group IV element such as carbon, silicon or germanium, for example, at least one of a carbon element thin film, a silicon element thin film, a germanium element thin film, a silicon carbide thin film and a germanium silicide thin film or a combination thereof in a monocrystalline phase, a polycrystalline phase, an amorphous phase or a microcrystalline phase. In an embodiment, apart from being made of silicon thin films, the first photovoltaic layer **232** and the second photovoltaic layer **234** may also be made of copper indium gallium selenium (CIGS), cadmium telluride (CdTe) or a combination thereof, in which case the thin-film solar cell **200** of this embodiment will become a CIGS thin-film solar cell or a thin-film CdTe solar cell.

In another embodiment, the first photovoltaic layer **232** and the second photovoltaic layer **234** may also be made of a material selected from a group III-V compound semiconductor thin film, a group II-VI compound semiconductor thin film, an organic compound semiconductor thin film, or a combination thereof. For example, the group III-V compound semiconductor thin film includes at least one of a gallium arsenide (GaAs) compound thin film and an indium gallium phosphide (InGaP) compound thin film, or a combination thereof. The group II-VI compound semiconductor thin film comprises at least one of a copper indium selenium (CIS) compound thin film, a copper indium gallium selenium (CIGS) compound thin film and a cadmium telluride (CdTe) compound thin film, or a combination thereof. The organic compound semiconductor thin film comprises a mixture of a conjugated polymer donor and a carbon nanosphere acceptor.

Further referring to **FIG 2****,** the second conductive layer **240** is disposed on the first photovoltaic layer **232** and the second photovoltaic layer **234.** The second conductive layer **240** may be made of a material described with reference to the aforesaid transparent conductive layer, so no further description will be made thereon herein. In this embodiment, the first conductive layer **220** and the second conductive layer **240** are, for example, both transparent conductive layers. In another embodiment not shown, the second conductive layer **240** may also be a stack formed by a reflective layer and the aforesaid transparent conductive layer, with the reflective layer being disposed between the transparent conductive layer and the substrate **210.** The reflective layer may be made of a metal with desirable reflectivity such as aluminum (Al), silver (Ag), molybdenum (Mo) or copper (Cu). In other words, the design in terms of this may be varied depending on different requirements of users (e.g., depending on whether the thin-film solar cell to be fabricated is to receive light on both surfaces or on only a single surface), and what described above is only for illustration purpose but is not to limit the present invention.

In addition, the first passivation layer **252** is disposed on the second conductive layer **240,** and the second passivation layer **254** is disposed on the first passivation layer **252,** The first passivation layer **252** and the second passivation layer **254** are used to reflect light rays **L** within a wavelength range into the first photovoltaic layer **232** and the second photovoltaic layer 234 so as to make photocurrents generated by the first photovoltaic layer **232** and the second photovoltaic layer **234** matched with each other.

In this embodiment, the aforesaid wavelength range may substantially range from 700 nm to the infrared (IR) band. In other embodiments, the aforesaid wavelength range may substantially range from 700 nm to the ultraviolet (UV) band. The wavelength range of light rays to be reflected by the first passivation layer **252** and the second passivation layer **254** depends on the light absorptive wavelength range of the first photovoltaic layer **232** or the light absorptive wavelength range of the second photovoltaic layer **234,** which will be detailed hereinafter.

In this embodiment, a design in which the first passivation layer **252** has a refractive index different from that of the second passivation layer **254** may be adopted so that an effect similar to total reflection is obtained at an interface R between the first passivation layer 252 and the second passivation layer 254 to reflect light rays L within a desired wavelength range. More specifically, if the first photovoltaic layer **232** is made of an amorphous silicon and the second photovoltaic layer **234** is made of a microcrystalline or polycrystalline silicon, then short-wavelength portions of the light rays **L** (e.g., sunlight) from the outside will mostly be absorbed by the first photovoltaic layer **232** to generate a photocurrent while long-wavelength portions of the light rays be mostly absorbed by the second photovoltaic layer **234** to generate a photocurrent, Generally, the photocurrent generated by the first photovoltaic layer **232** is larger than that generated by the second photovoltaic layer **234.** However, through the design of the first passivation layer **252** and the second passivation layer **254** as described above, the thin-film solar cell of this embodiment can reflect light rays L within a wavelength range of about 700 nm to the infrared band back into the second photovoltaic layer **234** to increase the photocurrent generated by the second passivation layer **254,** In this way, the photocurrent generated by the second photovoltaic layer **234** can be made to be matched with the photocurrent generated by the first photovoltaic layer **232.** Thus, the photoelectric conversion efficiency of the thin-film solar cell **200** as a whole gets improved.

Conversely, in other embodiments, if the photocurrent generated by the first photovoltaic layer **232** is smaller than that generated by the second photovoltaic layer **234,** then light rays **L** within a wavelength range from about 700 nm to the UV band can be reflected back into the first photovoltaic layer **232** to achieve the same objectives and functionalities as described above.

Additionally, in this embodiment, the first passivation layer **252** has a thickness identical to that of the second passivation layer **254.** However, in other embodiments, the first passivation layer **252** may also have a thickness different from that of the second passivation layer **254,** Particularly, those of ordinary skill in the art may adjust the thicknesses of the first passivation layer **252** and the second passivation layer **254** depending on practical requirements so as to further improve the current matching effect.

In another embodiment, the first passivation layer **252** may be made of a light transmissive material and the second passivation layer **254** may be made of a reflective material straightforwardly. The reflective material of the second passivation layer **254** is mainly intended to reflect the light rays L within the aforesaid wavelength range into the first photovoltaic layer **232** or the second photovoltaic layer **234.** In other words, besides the way of utilizing the interface **R** between two passivation layers of different refractive indices to reflect the light rays L, an externally applied reflective material may be directly used to reflect the light rays L.

In this embodiment, the first passivation layer **252** and the second passivation layer **254** may be made of a dielectric material, an insulation material, a compound comprising one of the oxygen and nitrogen element, or a combination thereof. For example, the first passivation layer **252** and the second passivation layer **254** may be made of silicon oxide, silicon nitrogen, silicon oxynitride, or a combination thereof; this may vary depending on requirements and design of users, and what described above is only for purpose of illustration but is not to limit the present invention.

Hereinbelow, a method for manufacturing the thin-film solar cell **200** will be described.

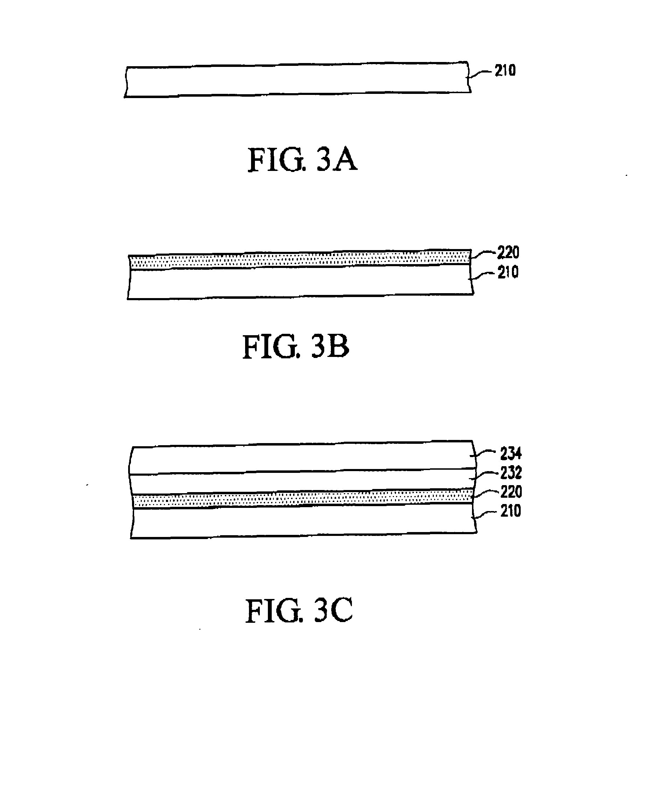

**FIGs. 3A** to **3F** illustrate a process of manufacturing a thin-film solar cell according to an embodiment of the present invention. Firstly, referring to **FIG. 3A****,** a substrate **210** is provided. The substrate **210** is, for example, a glass substrate.

Then, referring to **FIG. 3B****,** a first conductive layer **220** is formed on the substrate **210.** In this embodiment, the first conductive layer **220** may be made of the material described with reference to the aforesaid transparent conductive layer and formed through, for example, a sputtering process, a metal organic chemical vapor deposition (MOCVD) process or an evaporation process.

Next, referring to **FIG. 3C****,** a first photovoltaic layer **232** and a second photovoltaic layer **234** are stacked on the first conductive layer **220.** The first photovoltaic layer **232** and the second photovoltaic layer **234** are each adapted to generate a photocurrent and are in electrical tandem with each other. In this embodiment, the first photovoltaic layer **232** and the second photovoltaic layer **234** may be formed through, for example, a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process. Deposition thicknesses of the first photovoltaic layer **232** and the second photovoltaic layer **234** may be determined depending on requirements of users,

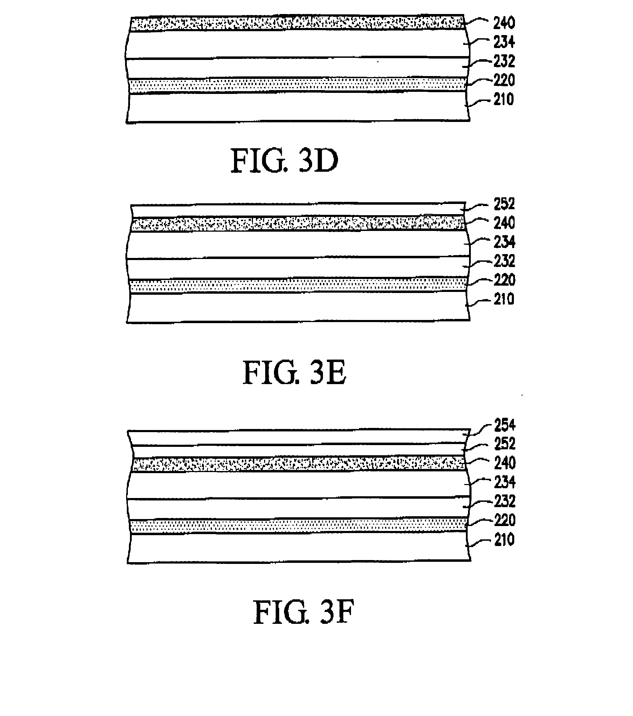

Subsequently, referring to **FIG. 3D****,** a second conductive layer **240** is formed on the first photovoltaic layer **232** and the second photovoltaic layer **234.** In this embodiment, the second conductive layer **240** may be formed through, for example, the sputtering process, the MOCVD process or the evaporation process described above, and is made of, for example, the transparent conductive layer described above. Hence, no further description will be made thereon herein.

Afterwards, referring to **FIG 3E****,** a first passivation layer **252** is formed on the second conductive layer **240.** In this embodiment, the first passivation layer **252** may be formed by, for example, performing a screen printing process, a dry film lamination process or a coating process and then optionally performing a curing process.

Finally, referring to **FIG 3F****,** a second passivation layer **254** is formed on the first passivation layer **252.** In this embodiment, the second passivation layer **254** is formed in a way similar to that of the first passivation layer **252,** i.e., by firstly performing a screen printing process, a dry film lamination process or a coating process and then optionally performing a curing process. Thus, the method for manufacturing the thin-film solar cell **200** shown in **FIG 2** is completed.

It shall be particularly noted that, before forming the first passivation layer 252 or the second passivation layer **254,** this embodiment further comprises measuring magnitudes of the photocurrents supplied by the first photovoltaic layer **232** and the second photovoltaic layer **234.** For example, before forming the first passivation layer **252,** magnitudes of two photocurrents supplied by the first photovoltaic layer **232** and the second photovoltaic layer **234** are measured at first. Then if the photocurrent generated by the second photovoltaic layer **234** is smaller than that generated by the first photovoltaic layer **232,** a wavelength range of light rays L that can be reflected by the first passivation layer **252** and the second passivation layer **254** may be adjusted in such a way that the light rays **L** adapted to be absorbed by the second photovoltaic layer **234** is reflected into the second photovoltaic layer **234.** On the other hand, if the photocurrent generated by the first photovoltaic layer **232** is smaller than that generated by the second photovoltaic layer **234,** the wavelength range of light rays L that can be reflected by the first passivation layer **252** and the second passivation layer **254** may be adjusted in such a way that the light rays L adapted to be absorbed by the first photovoltaic layer **232** is reflected into the first photovoltaic layer **232.** Thus, by appropriately increasing the photocurrent generated by the first photovoltaic layer **232,** the photocurrents generated by the first photovoltaic layer **232** and the second photovoltaic layer **234** can be made to be matched with each other.

The aforesaid manufacturing method is only described as an example, and in other possible embodiments, a thin-film solar cell having three or more photovoltaic layers may also be manufactured through a manufacturing method similar to what described above.

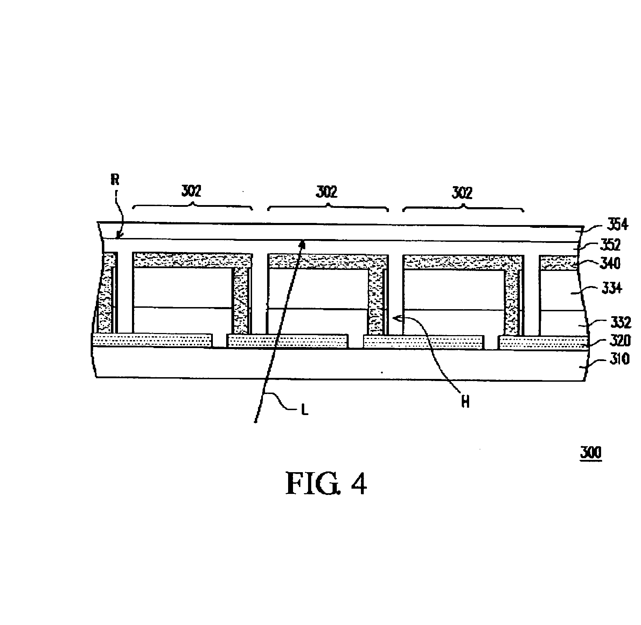

**FIG 4** is a schematic view of a thin-film solar cell according to another embodiment of the present invention. Referring to **FIG 4****,** the thin-film solar cell 300 comprises a substrate **310,** a plurality of sub-cells **302,** a first passivation layer **352** and a second passivation layer **354.** The sub-cells **302** are disposed on the substrate **310.** Each of the sub-cells **302** comprises a first conductive layer **320,** a first photovoltaic layer **332,** a second photovoltaic layer **334** and a second conductive layer **340.**

The first conductive layer **320** is disposed on the substrate **310.** The first photovoltaic layer **332** and the second photovoltaic layer **334** are stacked on the first conductive layer **320** and are in electrical tandem with each other. Each of the first photovoltaic layer **332** and the second photovoltaic layer **334** is adapted to generate a photocurrent and has an opening H exposing the first conductive layer **320.** The second conductive layer **340** is disposed on the first photovoltaic layer **332** and the second photovoltaic layer **334,** and is electrically connected with the first conductive layer **320** of an adjacent sub-cell **302** through the opening **H.**

The first passivation layer **352** is disposed on the second conductive layer **340** of each of the sub-cells **302.** The second passivation layer **354** is disposed on the first passivaiton layer **352.** The first passivation layer **352** and the second passivation layer **354** are used to reflect light rays **L** within a wavelength range into the first photovoltaic layer **332** and the second photovoltaic layer **334** so that the photocurrents generated by the first photovoltaic layer **332** and the second photovoltaic layer **334** are matched with each other.

In this embodiment, the thin-film solar cell **300** is of a solar cell structure comprised of a plurality of sub-cells **302** in electrical tandem with each other. Because the first passivation layer **352** and the second passivation layer **354** of the thin-film solar cell **300** are substantially identical to the first passivation layer **252** and the second passivation layer **254** of the thin-film solar cell **200,** the thin-film solar cell **300** can also achieve the same objectives and functionalities as the thin-film solar cell **200.**

According to the above descriptions, the thin-film solar cell of the present invention has the first and the second passivation layers disposed on the plurality of photovoltaic layers, so when photocurrents generated by the plurality of photovoltaic layers have different magnitudes, light rays within a specific wavelength range may be reflected by the first passivation and the second passivation layers into the plurality of photovoltaic layers to make the photocurrents matched with each other. In other words, the thin-film solar cell of the present invention can present an improved photoelectric conversion efficiency. In addition, the method for manufacturing a thin-film solar cell of the present invention can form the two passivation layers in the thin-film solar cell through a simplified process, thereby improving the performance of the resulting solar cell.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A thin-film solar cell, comprising:
a substrate;
a first conductive layer disposed on the substrate;
a plurality of photovoltaic layers stacked on the first conductive layer and in electrical
tandem with each other, wherein each of the photovoltaic layers is adapted to generate a photocurrent;
a second conductive layer disposed on the photovoltaic layers;
a first passivation layer disposed on the second conductive layer; and
a second passivation layer disposed on the first passivation layer,
wherein the first passivation layer and the second passivation layer are used to reflect a
light ray within a wavelength range into the photovoltaic layers so as to make the photocurrents generated by the photovoltaic layers matched with each other.

2. The thin-film solar cell as claimed in claim 1, wherein the wavelength range substantially ranges from the ultraviolet (UV) band to the infrared (IR) band.

3. The thin-film solar cell as claimed in claim 1, wherein the wavelength range substantially ranges from 300 nm to 1100 nm.

4. The thin-film solar cell as claimed in claim 1, wherein the first passivation layer has a refractive index different from that of the second passivation layer.

5. The thin-film solar cell as claimed in claim 1, wherein the first passivation layer is made of a light transmissive material and the second passivation layer is made of a reflective material, and the second passivation layer is used to reflect the light ray within the wavelength range into the photovoltaic layers.

6. The thin-film solar cell as claimed in claim 1, wherein the first passivation layer has a thickness identical to that of the second passivation layer.

7. The thin-film solar cell as claimed in claim 1, wherein the first passivation layer has a thickness different from that of the second passivation layer.

8. The thin-film solar cell as claimed in claim 1, wherein the first passivation layer and the second passivation layer are made of a dielectric material, an insulation material, a compound comprising one of the oxygen and nitrogen element, or a combination thereof, wherein the compound are selected from a group consisting of oxide, silicon nitride, silicon oxynitride, or a combination thereof.

9. The thin-film solar cell as claimed in claim 1, wherein the photovoltaic layers include a stack structure of a tandem junction design, a triple junction design or having more than three junctions, and the photovoltaic layer is made of a group IV element semiconductor thin film, a group III-V compound semiconductor thin film, a group II-VI compound semiconductor thin film, an organic compound semiconductor thin film, or a combination thereof, wherein the group IV element semiconductor thin film comprises at least one of a carbon element thin film, a silicon element thin film, a germanium elemental thin film, a silicon carbide thin film and a germanium silicide thin film or a combination thereof in a monocrystalline phase, a polycrystalline phase, an amorphous phase or a microcrystalline phase, the group III-V compound semiconductor thin film comprises at least one of a gallium arsenide (GaAs) compound thin film and an indium gallium phosphide (InGaP) compound thin film, or a combination thereof, and the group II-VI compound semiconductor thin film comprises at least one of a copper indium selenium (CIS) compound thin film, a copper indium gallium selenium (CIGS) compound thin film and a cadmium telluride (CdTe) compound thin film, or a combination thereof,

10. The thin-film solar cell as claimed in claim 9, wherein the organic compound semiconductor thin film comprises a mixture of a conjugated polymer donor and a carbon nanosphere acceptor.

11. The thin-film solar cell as claimed in claim 1, wherein the first conductive layer and the second conductive layer are made of a transparent conductive layer.

12. A method for manufacturing a thin-film solar cell, comprising:
providing a substrate;
forming a first conductive layer on the substrate;
stacking a plurality of photovoltaic layers on the first conductive layer, wherein the
photovoltaic layers are in electrical tandem with each other and each of the photovoltaic layers is adapted to generate a photocurrent;
forming a second conductive layer on the photovoltaic layers;
forming a first passivation layer on the second conductive layer; and
forming a second passivation layer on the first passivation layer, wherein the first
passivation layer and the second passivation layer are each adapted to reflect a light ray within a wavelength range into the photovoltaic layers so as to make the photocurrents generated by the photovoltaic layers matched with each other.

13. The method for manufacturing a thin-film solar cell as claimed in claim 12, further comprising measuring magnitudes of the photocurrents supplied by the photovoltaic layers before forming the first passivation layer or the second passivation layer.

14. The method for manufacturing a thin-film solar cell as claimed in claim 12, wherein forming the first passivation layer and the second passivation layer comprises performing a screen printing process, a dry film lamination process or a coating process, and performing a curing process,

15. Athin-film solar cell, comprising:
a substrate;
a plurality of sub-cells disposed on the substrate, wherein each of the sub-cells
comprises:
a first conductive layer disposed on the substrate;
a plurality of photovoltaic layers stacked on the first conductive layer and in
electrical tandem with each other, wherein each of the photovoltaic layers is adapted to generate a photocurrent, and the photovoltaic layers have an opening exposing the first conductive layer;
a second conductive layer disposed on the photovoltaic layers and electrically
connected with the first conductive layer of an adjacent one of the sub-cells through the opening;
a first passivation layer disposed on the second conductive layer of each of the sub-cells;
and
a second passivation layer disposed on the first passivation layer,
wherein the first passivation layer and the second passivation layer are used to reflect a
light ray within a wavelength range into the photovoltaic layers so as to make the photocurrents generated by the photovoltaic layers matched with each other.
